# EUROPÄISCHE PATENTSCHRIFT

(11) **EP 0 630 874 B1**
(45) Veröffentlichungstag und Bekanntmachung des Hinweises auf die Patenterteilung: **11.02.1998**
(21) Anmeldenummer: 94109173.8
(22) Anmeldetag: 15.06.1994
(51) Int. Cl.: C04B 35/00, H01L 39/24

(54) **Verfahren zur Herstellung rohrförmiger Formteile aus Hoch-Tc-Supraleiter-Material**
Process for the production of tubular-shaped articles of high-Tc superconducting material
Procédé de production d'articles de forme tubulaire en matériau supraconducteur à haute température

(30) Priorität: 23.06.1993 DE 4320753
(43) Veröffentlichungstag der Anmeldung: 28.12.1994
(73) Patentinhaber: HOECHST AKTIENGESELLSCHAFT, 65929 Frankfurt am Main (DE)
(72) Erfinder: Lang, Christoph, Dr., D-65929 Frankfurt (DE); Küllmer, Iris, D-60529 Frankfurt (DE); Bock, Joachim, Dr., D-50374 Erftstadt (DE)

(56) Entgegenhaltungen:
- EP-A- 0 441 219
- EP-A- 0 462 409
- EP-A- 0 571 885
- JP-A- 3 093 609
- DATABASE WPI Week 8951, Derwent Publications Ltd., London, GB; AN 89-373416 & JP-A-1 278 420 (MEIDENSHA ELEC. MFG. KK) 8. November 1989
- DATABASE WPI Week 8942, Derwent Publications Ltd., London, GB; AN 89-304273 & JP-A-1 224 224 (UBE INDUSTRIES KK) 7. September 1989

## Beschreibung

Die vorliegende Erfindung beschreibt ein Verfahren zur Herstellung zylinderförmiger oder runder Formteile aus Hoch-T_{c}-Supraleitern enthaltend die Oxide der Metalle Bi, Sr, Ca und Cu.

Ein wichtiges Anwendungsgebiet keramischer Hochtemperatursupraleiter ist die Elektrotechnik. Dabei ist es wesentlich, das keramische Material über einen Formgebungsprozeß für den jeweiligen Einsatzzweck zu verarbeiten. Einen Fortschritt in dieser Richtung hat es für das Material Bi₂Sr₂CaCu₂O₈₊ₓ durch die Einführung eines Schmelzgießprozesses gegeben, der in der DE-OS-38 30 092 beschrieben ist. Danach sind Vollmaterialteile wie Stäbe, Platten, etc. zugänglich. Eine Erweiterung der Gestaltungsmöglichkeiten ist die Formgebung über einen Schleuderguß der keramischen Schmelze. Diese Technik ist in der DE-OS 40 19 368 beschrieben. Die Verarbeitung nach der Lehre dieser Druckschrift hat bezüglich der Dimensionen der Formteile, die damit erreichbar sind, jedoch deutliche Einschränkungen. Die Dicke des schleudergegossenen Materials liegt aus Stabilitätsgründen im Millimeter- bis Centimeter-Bereich und der Durchmesser von Ringen beziehungsweise von Rohren ist sehr begrenzt. Außerdem ist die erreichbare kritische Stromdichte dieser Vollmaterialproben stark verbesserungswürdig, weil eine Texturierung des elektrisch anisotropen Materials praktisch nicht durchführbar ist.

Das von J. Shiomoyama et al. in Jpn. 1. Appl. Phys. Vol. 31 (1992), S. 163-165, beschriebene Foliengießen, das für das System Bi₂Sr₂CaCu₂O₈₊ₓ zu hohen Stromdichten führt, eignet sich auch nicht unbeschränkt für Ringe oder ähnliche runde Geometrien, da Nahtstellen bei der nachträglichen Formgebung entstehen, die ihrerseits limitierend auf die kritische Stromdichte wirken.

JP -1-278420 lehrt ein Verfahren zur Herstellung von Hochtemperatursupraleitern auf Basis BiSrCaCuO mit bestimmten Molverhältnissen, bei dem die oxidischen und karbonatischen Ausgangspulver gemischt und mit Polyvinylalkohol als Binder versehen werden, die Mischung gesiebt und gepreßt wird und die so erhaltenen Formkörper in Sauerstoff-haltiger Atmosphäre bei 830 bis 880 °C gesintert werden.

JP-3-093609 beschreibt ein ähnliches Verfahren zur Herstellung von Hochtemperatursupraleitern auf Basis BiPbSrCaCuO, bei dem zuerst Oxalate hergestellt und diese thermisch zersetzt werden.

Es bestand also die Aufgabe, ein neues Verfahren zu entwickeln, nach dem Formteile aus hoch-T_{c}-supraleitendem Material mit hohen kritischen Stromdichten und variabler Geometrie herzustellen sind.

Gelöst wird diese Aufgabe durch ein Verfahren der eingangs genannten Gattung, dessen kennzeichnende Merkmale darin zu sehen sind, daß eine vorpräparierte feinteilige Oxidmischung mit organischen Additiven und mit Lösungsmittel zu einem Schlicker verarbeitet wird, daß der Schlicker bei Raumtemperatur in einen drehbaren Hohlzylinder eingebracht wird, daß die Mischung beim Drehen des Hohlzylinders gleichmäßig verteilt wird, während das Lösungsmittel zu verdampfen anfängt, und daß die geformte Mischung durch thermische Nachbehandlung in das supraleitende Formteil überführt wird.

Das erfindungsgemäße Verfahren kombiniert die Vorteile des Schleudergießens mit denen des Foliengießens und erlaubt es, bei Raumtemperatur mit optimiertem Precursormaterial in einer organischen Formulierung dünne Schichten mit reproduzierbarer Schichtdicke auf Substratmaterial aufzubringen und mit geeigneter thermischer Nachbehandlung zu rohrförmigen Bauteilen mit hohen kritischen Stromdichten umzusetzen.

An das pulverförmige keramische Ausgangsmaterial (Precursormaterial) müssen zur Verarbeitung mit einer organischen Formulierung zu einem Schlicker mehrere Anforderungen gestellt werden. Die mittlere Korngröße (der d₅₀-Wert) sollte klein und die Elementverteilung, d.h. die Verteilung der verschiedenen Phasen im Precursormaterial, sehr homogen sein. Je reproduzierbarer die Eigenschaften des eingesetzten Materials sind, desto reproduzierbarer sind auch die Eigenschaften des Schlickers und letztlich auch die supraleitenden Eigenschaften des aus dem Schlicker hergestellten Formteils.

Als bevorzugtes Ausgangsmaterial kommt ein naßchemisch hergestelltes Precursormaterial in Frage, das über einen SOL-GEL-Prozeß, über ein Lösungsverfahren, wie Gefriertrocknung oder über eine Copräzipitation wie eine Oxalatfällung hergestellt wurde.

Zur Vorpräparierung wird das Precursormaterial insbesondere thermisch behandelt. Hierzu wird beispielsweise das Copräzipitat über einen Zeitraum von 10 min bis 2 h bei Temperaturen im Bereich von 250 bis 800 °C in einer sauerstoffhaltigen Atmosphäre zersetzt.

Als organische Additive werden den Oxiden Dispergierhilfsmittel, Weichmacher und Binder beigegeben. Als Dispergierhilfsmittel kommen Verbindungen wie tertiäres Alkoxylamin mit einer Alkylgruppe mit 10 bis 21 C-Atomen in Frage. Als Weichmacher können beispielsweise Phthalsäureester eingesetzt werden. Geeignete Binder sind langkettige organischer Ester mit mindestens 17 C-Atomen.

Um die Mischung aus Metalloxiden und organischen Additiven gießfähig zu machen wird zusätzlich noch ein Lösungsmittelgemisch zugesetzt, das vorzugsweise aus Toluol und Ethanol im Verhältnis 20 bis 40 Gew.-% Toluol und 60 bis 80 Gew.-% Ethanol besteht. Vorzugsweise enthält eine so hergestellte Gießmasse 50 bis 60 Gew.-% keramisches Material, 30 bis 45 Gew.-% Lösungsmittel, 0,2 bis 4 Gew.-% Dispergiermittel, 1 bis 6 Gew.-% Binder und 0.2 bis 2 Gew.-% Weichmacher, jeweils bezogen auf das Gesamtgewicht der Gießmasse.

Mit dem erfindungsgemäßen Verfahren können in Ergänzung zum Foliengießprozeß auch runde beziehungsweise rohrförmige Geometrien beschichtet werden. Dazu wird ein geeignetes Substrat in eine Kokille aus beliebigem Material eingespannt, die drehbar gelagert ist. Während des Drehens wird Schlicker auf der Basis des copräzipitierten BSCCO-Precursormaterial in die Kokille auf die Substratoberfläche gegeben. Durch den Drehvorgang wird der Schlicker gleichmäßig verteilt, während das Lösungsmittel anfängt zu verdampfen. Vorzugsweise ist die Umdrehungszahl regelbar und beträgt 100 bis 6000 rpm, besonders bevorzugt 2000 bis 3000 rpm. Insbesondere wird der Querschnitt der Kokille auf der offenen Stirnseite mit einem Abschlußring verringert.

Es entsteht eine Grünfolie, die eine gleichmäßige Dicke und eine homogene Verteilung des Precursors aufweist. Anschließend wird das Bauteil einer thermischen Nachbehandlung unterzogen, die zum Verbund Substrat-Supraleiter führt. Vorzugsweise wird das rohrförmige Bauteil durch geeignete thermische Nachbehandlung zwischen 600°C und 920°C in ein supraleitendes Bauteil mit hoher kritischer Stromdichte umgesetzt, das überwiegend die Zielverbindung mit der Idealzusammensetzung Bi₂Sr₂CaCu₂O₈₊ₓ oder Bi₂Sr₂Ca₂Cu₃O₁₀₊ₓ enthält. Ist das Substratmaterial Ag und der Supraleiter Bi₂Sr₂CaCu₂O₈₊ₓ, kann mit einem partiellen Schmelzschritt und nachfolgender langsamer Kristallisation ein rohrförmige Bauteil mit einer supraleitenden bis zu 10 µm dünnen und dichten, hochtexturierten Schicht erhalten werden, das eine kritische Stromdichte (gemessen an Kurzproben über ca. 1 cm) bis zu 10⁴ A/cm² aufweist. Auch die kristalline Phase mit der Idealzusammensetzung Bi₂Sr₂Ca₂Cu₃O₁₀₊ₓ ist eine der Zielverbindungen.

Ein weiterer Vorteil des erfindungsgemäßen Verfahrens ist, daß über mehrere Schlickerschleudergußschritte auch Laminate mit beliebiger Kombination (keramisches) Substrat und Supraleiter erhalten werden können. So kann im ersten Schritt durch Verwendung eines Keramikschlickers (z.B. Al₂O₃) ein Substratformteil beliebiger Dicke nach Ausbrennen der Organik hergestellt werden. In einem zweiten Schritt wird mit beliebiger Technik eine Sperrschicht, vorzugsweise Silber, aufgebracht, die eine Teilchendiffusion in den Supraleiter verhindert. Wenn Ag auf Al₂O₃ aufgebracht wird, sind die galvanische Versilberung, Sputtern oder mechanisches Aufbringen einer Einbrennschicht gut geeignete Auftragsverfahren. Die Sperrschicht kann dann mit dem Supraleiterschlicker beschichtet und das Laminat wiederum zum supraleitenden Bauteil thermisch umgesetzt werden. Entsprechend lassen sich mehrere Beschichtungen Substrat/Supraleiter in beliebiger Reihenfolge realisieren.

Die vorstehend beschriebene Vorgehensweise ist besonders geeignet, um die Dicke der Sperrschicht zu erniedrigen. So ist es für die Anwendung von Bi₂Sr₂CaCu₂O₈₊ₓ auf Ag im Wechselstromfeld wichtig, zur Reduktion von Wechselstromveriusten den Metallanteil zu minimieren. Im allgemeinen sind die Materialien für diese Sperrschichten (Bufferschichten) auch hochwertiger als das Substratmaterial, so daß auch ein wirtschaftlicher Aspekt hinzukommt.

Für die nachfolgend zur besseren Erläuterung der Erfindung angegebenen Ausführungsbeispiele wurde durch Copräzipitation hergestelltes Material eingesetzt.

### Beispiel 1

Ein Oxalatcopräzipitat mit der formalen Zusammensetzung Bi₂Sr₂CaCu₂ wird bei 450 °C vorkalziniert. Es entsteht im wesentlichen eine feinteilige, homogene Oxidmischung, die mit 38 Gew.% Lösungsmittelgemisch Toluol/Ethanol 32:68), 1 Gew.% Dispergiermittel (®Genamin CO 20, Hoechst AG), 3 Gew.% Binder (®Acryloid, Rhom und Haas) und 2 Gew.% Weichmacher (®Palatinol C, BASF AG) zu einem Schlicker verarbeitet wird. Im ersten Schritt wird der vorkalzinierte Precursor mit dem Lösungsmittel und dem Dispergiermittel 3 Stunden im Taumler homogenisiert, dann wird mit Ultraschall die Suspension entgast. Anschließend wird der Binderanteil und der Weichmacher hinzugesetzt und wieder im Taumler 3 Stunden homogenisiert sowie entgast. In einen drehbaren Hohlzylinder aus Aluminium mit 4 cm Durchmesser und 4 cm Höhe wird anschließend ein Stück Ag-Rohr mit der Wanddicke 100 µm eingepaßt. Bei 3000 Umdrehungen werden ca. 2 ml Schlicker mit ca. 60% Feststoffgehalt eingespritzt. Nach Verdampfen des Lösungsmittelgemisches Toluol/Ethanol entsteht eine rißfreie Grünschicht mit einer Schichtdicke von ca. 50-60 µm. Bei einer thermischen Nachbehandlung von 2 Stunden bei 500°C wird die verbleibende Organik weitestgehend ausgeheizt. Es folgt nach dem Aufheizen mit 2,5 K/min ein partieller Schmelzschritt bei 885°C über ein Zeitintervall von 10 min mit anschließender Rekristallisation zwischen 875 und 850°C mit einer Abkühlrate von 1°C/h. Nach 2 h Nachtempern unter Ar bei 650°C weist der Film eine supraleitende Sprungtemperatur (T_{c50}) von 91 K auf und zeigt kritische Stromdichten (gemessen an herauspräparierten Kurzproben) bis zu 1*10⁴ A/cm². Eine Röntgenmessung zeigt das Vorliegen einer c-Achsenorientierung >95%. Der so hergestellte Film hat eine mittlere Dicke von 20 µm, die mit Hilfe optischer Schliffbilder ermittelt wurde.

### Beispiel 2

Analog zu Beispiel 1 erfolgt die Herstellung des Precursormaterials sowie die Verarbeitung zum Schlicker. Durch Einspritzen auf einen Silberzylinder, der an einem drehbaren Aluminiumzylinder anliegt, wird bei 2000 U/min eine 2 mm starke Grünschicht erzeugt. Nach Verdampfen des Lösungsmittels beträgt die Schwankung der Schichtdicke ca. 10%. Der partielle Schmelzschritt nach dem Aufheizschritt mit 3 K/min dauert bei 890°C 5 min, die Rekristallisation wird zwischen 870 und 850°C mit einer Abkühlgeschwindigkeit von 2 K/h durchgeführt. Der so hergestellte supraleitende Film weist eine mittlere Schichtdicke von 1 mm auf. Nach identischer Temperung unter Ar zeigt er ein T_{c} von 90 K und ein J_{c} von 6300 A/cm² (herauspräparierte Kurzprobe).

### Beispiel 3

Analog zu Beispiel 1 erfolgt die Herstellung des Precursormaterials und die Verarbeitung zum Schlicker. Durch Einspritzen auf den Silberzylinder wird bei 2500 U/min. eine ca. 25 µm starke Grünschicht erzeugt. Nach Verdampfen des Lösungsmittels beträgt die Schwankung der Schichtdicke ca. 20%. Der partielle Schmelzschritt nach dem Aufheizschritt mit 3 K/min dauert bei 885°C 10 min, die Rekristallisation wird zwischen 872 und 850°C mit 1 K/h durchgeführt. Der supraleitende Film hat eine mittlere Schichtdicke von 12 µm. Nach 2 h Temperung unter Ar zeigt er ein T_{c} von 92 K mit einer Übergangsbreite von 0,8 K und ein J_{c} von 8200 A/cm² (herauspräparierte Kurzprobe).

## Patentansprüche

1. Verfahren zur Herstellung zylinderförmiger oder runder Formteile aus Hoch-T_{c}-Supraleitermaterial enthaltend Bismut, Strontium, Calcium, Kupfer und Sauerstoff, dadurch gekennzeichnet, daß eine vorpräparierte feinteilige Oxidmischung mit organischen Additiven und mit Lösungsmittel zu einem Schlicker verarbeitet wird, daß der Schlicker bei Raumtemperatur in einen drehbaren Hohlzylinder eingebracht wird, daß die Mischung beim Drehen des Hohlzylinders gleichmäßig verteilt wird, während das Lösungsmittel zu verdampfen anfängt, und daß die geformte Mischung durch thermische Nachbehandlung in das supraleitende Formteil überführt wird.

2. Verfahren nach Anspruch 1, dadurch gekennzeichnet, daß Bismut partiell durch Blei ersetzt ist, wobei die Zielverbindungen die kristallinen Phasen mit der Idealzusammensetzung Bi₂Sr₂CaCu₂O₈₊ₓ und Bi₂Sr₂Ca₂Cu₃O₁₀₊ₓ sind.

3. Verfahren nach Anspruch 1, dadurch gekennzeichnet, daß das keramische Ausgangsmaterial zur Herstellung der gießfähigen Masse ein homogenes, feinteiliges Copräzipitat der Oxalate ist, das bei Temperaturen zwischen 250 und 800°C vorzersetzt wurde.

4. Verfahren nach Anspruch 3, dadurch gekennzeichnet, daß das keramische Ausgangsmaterial mit einem Lösungsmittelgemisch, einem Dispergiermittel, einem Binder und einem Weichmacher zu einer gießfähigen Masse verarbeitet wird.

5. Verfahren nach Anspruch 4, dadurch gekennzeichnet, daß das Lösungsmittelgemisch aus Toluol und Ethanol im Verhaltnis 20 bis 40 Gew.-% Tcluol und 60 bis 80 Gew-.% Ethanol besteht.

6. Verfahren nach Anspruch 4, dadurch gekennzeichnet, daß das Dispergiermittel ein tertiäres Alkoxylamin mit einer Alkylgruppe mit 10 bis 21 C-Atomen enthält.

7. Verfahren nach Anspruch 4, dadurch gekennzeichnet, daß der Binder ein langkettiger organischer Ester mit mindestens 17 C-Atomen ist.

8. Verfahren nach Anspruch 4, dadurch gekennzeichnet, daß der Weichmacher ein Phthalsäureester ist.

9. Verfahren nach einem der Ansprüche 1 bis 8, dadurch gekennzeichnet, daß die Gießmasse 50 bis 60 Gew.-% keramisches Material, 30 bis 45 Gew.-% Lösungsmittel, 0.2 bis 4 Gew.-% Dispergiermittel, 1 bis 6 Gew.-% Binder und 0.2 bis 2 Gew.-% Weichmacher, bezogen auf das Gesamtgewicht der Gießmasse, enthält.

10. Verfahren nach Anspruch 9, dadurch gekennzeichnet, daß die Gießmasse bei Raumtemperatur in eine drehbare Kokille vergossen wird.

11. Verfahren nach Anspruch 10, dadurch gekennzeichnet, daß die Umdrehungszahl regelbar ist und 100 bis 6000 rpm, vorzugsweise 2000 bis 3000 rpm, beträgt.

12. Verfahren nach Anspruch 10, dadurch gekennzeichnet, daß vorzugsweise als Substratmaterial ein einzupassendes rohrförmiges Bauteil aus Silber oder ein mit Silber beschichtetes keramisches Material verwendet wird.

13. Verfahren nach Anspruch 10, dadurch gekennzeichnet, daß der Querschnitt der Kokille auf der offenen Stirnseite mit einem Abschlußring verringert wird.

14. Verfahren nach Anspruch 10, dadurch gekennzeichnet, daß das rohrförmige Bauteil durch geeignete thermische Nachbehandlung zwischen 600°C und 920°C in ein supraleitendes Bauteil mit hoher kritischer Stromdichte umgesetzt wird, das überwiegend die Zielverbindung mit der Idealzusammensetzung Bi₂Sr₂CaCu₂O₈₊ₓ oder Bi₂Sr₂Ca₂Cu₃O₁₀₊ₓ enthält.

## Claims

1. A process for producing cylindrical or round parts of high-T_{c} superconductor material comprising bismuth, strontium, calcium, copper and oxygen, which comprises processing a pre-prepared finely-divided oxide mixture with organic additives and solvent to form a slip, introducing the slip at room temperature into a rotatable hollow cylinder, uniformly distributing the mixture by rotating the hollow cylinder while the solvent begins to evaporate, and converting the shaped mixture into the superconducting shaped part by subsequent thermal treatment.

2. The process as claimed in claim 1, wherein bismuth is partially replaced by lead, the target compounds being the crystalline phases having the ideal composition Bi₂Sr₂CaCu₂O₈₊ₓ and Bi₂Sr₂Ca₂Cu₃O₁₀₊ₓ.

3. The process as claimed in claim 1, wherein the ceramic starting material for producing the castable composition is a homogeneous, finely-divided coprecipitate of oxalates which has been pre-decomposed at temperatures between 250 and 800°C.

4. The process as claimed in claim 3, wherein the ceramic starting material is processed with a solvent mixture, a dispersant, a binder and a plasticizer to give a castable composition.

5. The process as claimed in claim 4, wherein the solvent mixture consists of toluene and ethanol in the ratio of from 20 to 40% by weight of toluene and from 60 to 80% by weight of ethanol.

6. The process as claimed in claim 4, wherein the dispersant comprises a tertiary alkoxylamine having an alkyl group having from 10 to 21 carbon atoms.

7. The process as claimed in claim 4, wherein the binder is a long-chain organic ester having at least 17 carbon atoms.

8. The process as claimed in claim 4, wherein the plasticizer is a phthalic ester.

9. The process as claimed in any one of claims 1 to 8, wherein the casting composition comprises from 50 to 60% by weight of ceramic material, from 30 to 45% by weight of solvent, from 0.2 to 4% by weight of dispersant, from 1 to 6% by weight of binder and from 0.2 to 2% by weight of plasticizer, based on the total weight of the casting composition.

10. The process as claimed in claim 9, wherein the casting composition is cast at room temperature into a rotatable mold.

11. The process as claimed in claim 10, wherein the rotation rate can be regulated and is from 100 to 6000 rpm, preferably from 2000 to 3000 rpm.

12. The process as claimed in claim 10, wherein a tubular component, which is to be fitted in, of silver or a silver-coated ceramic material is preferably used as substrate material.

13. The process as claimed in claim 10, wherein the cross section of the mold is reduced on the open end face by an end ring.

14. The process as claimed in claim 10, wherein the tubular component is converted by suitable subsequent thermal treatment between 600°C and 920°C into a superconducting component having a high critical current density and predominantly comprising the target compound having the ideal composition Bi₂Sr₂CaCu₂O₈₊ₓ or Bi₂Sr₂Ca₂Cu₃O₁₀₊ₓ.

## Revendications

1. Procédé pour fabriquer des objets cylindriques ou circulaires en un matériau supraconducteur à haute T_{c} contenant du bismuth, du strontium, du calcium, du cuivre et de l'oxygène, caractérisé en ce qu'on transforme en une barbotine un mélange d'oxydes finement divisé, préparé à l'avance, constitué d'additifs organiques et d'un solvant ; que l'on introduit la barbotine à la température ambiante dans un cylindre creux rotatif ; que l'on répartit uniformément le mélange lors de la rotation du cylindre creux, tandis que le solvant commence à s'évaporer, et que le mélange ainsi obtenu est, par un post-traitement thermique, converti pour donner l'objet supraconducteur.

2. Procédé selon la revendication 1, caractérisé en ce que le bismuth est partiellement remplacé par le plomb, les composés recherchés étant les phases cristallines ayant les compositions idéales Bi₂Sr₂CaCu₂O₈₊ₓ et Bi₂Sr₂Ca₂Cu₃O₁₀₊ₓ.

3. Procédé selon la revendication 1, caractérisé en ce que le matériau céramique de départ destiné à préparer la masse coulable est un coprécipité homogène et finement divisé des oxalates, qui au préalable a été décomposé à des températures de 250 à 800°C.

4. Procédé selon la revendication 3, caractérisé en ce que le matériau céramique de départ est, avec un mélange de solvants, un dispersant, un liant et un plastifiant, mis en oeuvre pour donner une masse coulable.

5. Procédé selon la revendication 4, caractérisé en ce que le mélange de solvants est constitué de toluène et d'éthanol selon un rapport de 20 à 40 % en poids de toluène et de 60 à 80 % en poids d'éthanol.

6. Procédé selon la revendication 4, caractérisé en ce que le dispersant contient une alcoxylamine tertiaire comportant un groupe alkyle ayant de 10 à 21 atomes de carbone.

7. Procédé selon la revendication 4, caractérisé en ce que le liant est un ester organique à longue chaîne ayant au moins 17 atomes de carbone.

8. Procédé selon la revendication 4, caractérisé en ce que le plastifiant est un ester de l'acide phtalique.

9. Procédé selon l'une des revendications 1 à 8, caractérisé en ce que la masse à couler contient de 50 à 60 % en poids d'un matériau céramique, de 30 à 45 % en poids d'un solvant, de 0,2 à 4 % en poids d'un dispersant, de 1 à 6 % en poids d'un liant et de 0,2 à 2 % en poids d'un plastifiant, par rapport au poids total de la masse à couler.

10. Procédé selon la revendication 9, caractérisé en ce que la masse à couler est coulée à la température ambiante, dans une coquille tournable.

11. Procédé selon la revendication 10, caractérisé en ce que la vitesse de rotation est réglable, et qu'elle est de 100 à 6000 et de préférence de 2000 à 3000 tr/min.

12. Procédé selon la revendication 10, caractérisé en ce qu'on utilise de préférence en tant que substrat un composant tubulaire pour insérer en argent ou encore un matériau céramique revêtu d'argent.

13. Procédé selon la revendication 10, caractérisé en ce que la section transversale de la coquille sur la face frontale ouverte est réduite à l'aide d'une bague d'obturation.

14. Procédé selon la revendication 10, caractérisé en ce que le composant tubulaire est converti par un post-traitement thermique approprié entre 600 et 920°C en un composant supraconducteur ayant une grande densité de courant critique, qui contient prépondérant le composé recherché, dont la composition idéale est Bi₂Sr₂CaCu₂O₈₊ₓ ou Bi₂Sr₂Ca₂Cu₃O₁₀₊ₓ.
